# EUROPEAN PATENT APPLICATION

(11) **EP 4 518 586 A1**
(43) Date of publication of application: **05.03.2025**
(21) Application number: 24194578.1
(22) Date of filing: 14.08.2024
(51) Int. Cl.: H05K 1/02, H05K 1/11, H05K 1/14, H01R 12/72, H05K 3/40

(54) **PRINTED CIRCUIT BOARD FOR PLUG-IN TYPE BREAKERS**

(30) Priority: 14.08.2023 IN 202341054504; 15.05.2024 US 202418665435
(71) Applicant: Vertiv Corporation, Westerville, OH 43082 (US)
(72) Inventor: SAM, Yahya, 12056 Arsta (SE); BADHE, Swapnil Prakash, 411043 Dhankawdi Pune (IN); BALAR, Singh, 411015 Pune Maharastra (IN)
(74) Representative: Bryn-Jacobsen, Caelia

(57) **Abstract**

A printed circuit board (PCB) is provided and includes a plurality of edge connectors, a pin connector, and a plurality of electrical lines each electrically connecting one of the plurality of edge connectors to the pin connector. The plurality of edge connectors are positioned on the PCB to enable the plurality of edge connectors to interface with respective connectors of a plurality of configurations of circuit breakers. The configurations may include a configuration including a first type of circuit breaker and a configuration including a second type of circuit breaker. The first and second types of circuit breakers may be 1-63 ampere (A) and 80-125A circuit breakers or 80-125A and 200A circuit breakers, or may be any of a variety of other types.

## Description

### CROSS-REFERENCE TO RELATED APPLICATION

This Application claims priority from Indian Patent Application No. 202341054504, filed August 14, 2023 in the Indian Patent Office.

### BACKGROUND

### 1. Field

Example embodiments relate to circuit breakers and, in particular, to a printed circuit board (PCB) configured to interface with different configurations of plug-in type circuit breakers.

### 2. Description of Related Art

A circuit breaker is an electrical switch designed to protect an electrical circuit from damage caused by an electrical fault (e.g., overcurrent/overload or short circuit). The basic function of a circuit breaker is to interrupt current flow after protective relays detect a fault. Busbars, metal bars used to carry current to and from various electrical components, distribute power from a power source to circuit breakers. If an electrical fault occurs in the circuit, a circuit breaker disposed downstream of the electrical fault is tripped (e.g., turned off or positioned in an open circuit position) and the faulty section of the busbar is disconnected from the circuit.

Various configurations of different types of circuit breakers can be connected through the busbar for the direct current (DC) transfer. The circuit breakers may be connected to a printed circuit board (PCB), also referred to in this context as a backboard, to transfer the tripping alarm signals to the system controller. However, when a circuit breaker configuration is modified, for example when the number or types of circuit breakers included in a configuration is changed, a different alarm connections must be thereto in order to accommodate the modified circuit breaker configuration.

In a related art design, a circuit breaker configuration also may be wired to an alarm board including alarm diodes connected to the circuit breakers within the configuration, the alarm board functioning as an alarm controller and connected to a system controller. In this way signals from each of the circuit breakers are routed to the alarm board, and alarm signals are routed from the alarm board to a system controller. Such an arrangement requires metal connections, wiring, and modifications depending on the particular configuration of circuit boards within the configuration.

### SUMMARY

Example embodiments may address at least the above problems and/or disadvantages and other disadvantages not described above. Also, example embodiments are not required to overcome the disadvantages described above, and may not overcome any of the problems described above.

According to an aspect of an example embodiment, a printed circuit board comprises: a plurality of edge connectors; a pin connector; a plurality of electrical lines, each electrically connecting one of the plurality of edge connectors to the pin connector; wherein each of the plurality of edge connectors is positioned on the printed circuit board to enable the plurality of edge connectors to interface with connectors of a plurality of configurations of circuit breakers, comprising at least: a first configuration comprising a circuit breaker of a first type, and a second configuration comprising a circuit breaker of a second type; wherein a position of a connector on the circuit breaker of the first type is different from a position of a connector on the circuit breaker of the second type; and wherein the printed circuit board has a thickness of not greater than 1.2 mm.

The circuit breaker of the first type may be a 1-63 ampere (A) circuit breaker, and the circuit breaker of the second type may be a 80-125A circuit breaker.

The circuit breaker of the first type may be a 80-125 ampere (A) circuit breaker, and the circuit breaker of the second type may be a 200A circuit breaker.

The printed circuit board may further comprise at least one connector configured to be electrically connected to a direct current surge protective device.

Each of the plurality of edge connectors may be a golden finger connector.

According to an aspect of another example embodiment, a printed circuit board comprises: a plurality of edge connectors, the plurality of edge connectors comprising at least one single edge connector and a pair of two dual edge connectors; a pin connector; a plurality of electrical lines comprising: at least one individual electrical line electrically connected between a single edge connector of the plurality of edge connectors and the pin connector, and at least one dual electrical line electrically connected between the pair of dual edge connectors and the at least one pin connector; a plurality of diodes, wherein one of the plurality of diodes is connected on one of the plurality of electrical lines; wherein each of the plurality of edge connectors is positioned on the printed circuit board to enable the plurality of edge connectors to interface with connectors of a plurality of configurations of circuit breakers, comprising at least: a first configuration comprising a circuit breaker of a first type, and a second configuration comprising a circuit breaker of a second type; wherein a position of a connector on the circuit breaker of the first type is different from a position of a connector on the circuit breaker of the second type; and wherein the printed circuit board has a thickness of not greater than 1.2 mm.

The circuit breaker of the first type may be a 1-63 ampere (A) circuit breaker, and the circuit breaker of the second type may be a 80-125A circuit breaker.

The circuit breaker of the first type may be a 80-125 ampere (A) circuit breaker, and the circuit breaker of the second type may be a 200A circuit breaker.

The printed circuit board may further comprise at least one connector configured to be electrically connected to a direct current surge protective device.

Each of the plurality of edge connectors may be a golden finger connector.

### BRIEF DESCRIPTION OF THE DRAWINGS

The above and/or other aspects will become apparent and more readily appreciated from the following description of example embodiments, taken in conjunction with the accompanying drawings, in which:
FIG. 1 illustrates related art plug-in circuit breakers;
FIG. 2 illustrates an overlapping of different configurations of plug-in circuit breakers;
FIG. 3 is a diagram of a printed circuit board (PCB) configured to interface with a number of different configurations of plug-in circuit breakers, according to an example embodiment;
FIG. 4 is a schematic diagram of a monitoring system, according to an example embodiment;
FIG. 5 illustrates two PCBs connected together, according to an example embodiment;
FIG. 6 illustrates a PCB configured to interface with a number of different configurations of plug-in circuit breakers, according to an example embodiment;
FIGs. 7A-7E illustrate examples of the PCB of FIG. 6 inserted into a different combinations of circuit breakers, according to an example embodiment;
FIG. 8 illustrates a PCB configured for use in conjunction with a combination of circuit breakers included on a controller shelf of a direct current power distribution unit (DCDU), according to an example embodiment;
FIG. 9 is a circuit diagram of the PCB of FIG. 8, according to an example embodiment;
FIG. 10 is a perspective diagram of the PCB of FIG. 8 inserted into a combination of circuit breakers on a controller shelf, according to an example embodiment;
FIG. 11 illustrates a PCB configured for use in conjunction with a combination of circuit breakers included on a distribution shelf, according to an example embodiment;
FIG. 12 is a circuit diagram of the PCB of FIG. 11, according to an example embodiment;
FIG. 13 is a perspective diagram of the PCB of FIG. 11 inserted into a combination of circuit breakers on a distribution shelf, according to an example embodiment;
FIG. 14 illustrates a PCB configured for use in conjunction with a combination of circuit breakers included on a battery fuse unit (BFU) shelf, according to an example embodiment;
FIG. 15 is a circuit diagram of the PCB of FIG. 14, according to an example embodiment;
FIG. 16 is a perspective diagram of the PCB of FIG. 14 inserted into a combination of circuit breakers on a BFU shelf, according to an example embodiment;
FIG. 17 illustrates a PCB configured for use in conjunction with a combination of circuit breakers included in a distribution box, according to an example embodiment;
FIG. 18 is a circuit diagram of the PCB of FIG. 17;
FIG. 19 is a perspective diagram of the PCB of FIG. 17 inserted into a combination of circuit breakers in a distribution box, according to an example embodiment;
FIG. 20 illustrates a PCB configured for use in conjunction with a combination of circuit breakers in a battery fuse unit (BFU) box, according to an example embodiment;
FIG. 21 is a circuit diagram of the PCB of FIG. 20, according to an example embodiment; and
FIG. 22 is a perspective diagram of the PCB of FIG. 20 inserted into a circuit breaker in a BFU box, according to an example embodiment.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including", "comprise, and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be repeated here in detail.

As used herein, unless otherwise stated, adjectives such as "substantially," "approximately," and "about" modifying a condition or relationship characteristic of a feature or features, are understood to mean that the condition or characteristic is defined to be within tolerances that are acceptable for operation of an example embodiment for an application for which it is intended.

Furthermore, it should be understood that spatial descriptions (e.g., "above," "below," "up," "left," "right," "down," "top," "bottom," "vertical," "horizontal," etc.) used herein are for purposes of illustration only, and that practical implementations of the structures described herein can be spatially arranged in any orientation or manner.

Example embodiments described herein are directed to a printed circuit board (PCB), alternately referred to herein as a backboard, configured to interface with multiple configurations of different types of plug-in circuit breakers without a need for a separate PCB to be configured for different configuration of circuit breakers. In the related art, a different busbar, and thus a different PCB, is required for each different configuration of circuit breakers. This creates a challenge for manufacturers that need to produce a different PCB for each circuit breaker configuration. Additionally, the lack of a universal PCB increases the complexity of installation and maintenance for end users.

Also conventionally, a circuit breaker configuration is connected, via a PCB, for example, to an alarm board, and from the alarm board to a system controller. As some circuit breakers include alarm diodes, but others do not, conventionally, the routing of alarm signals must be specifically taken into account for each different configuration of circuit breakers, adding further complexity for installation and maintenance.

One or more example embodiments described herein may provide advantages including simplified manufacturing, reduction of production costs, and streamlining of inventory management. Example embodiments may also offer a cost-effective and standardized solution for customers, making installation easier.

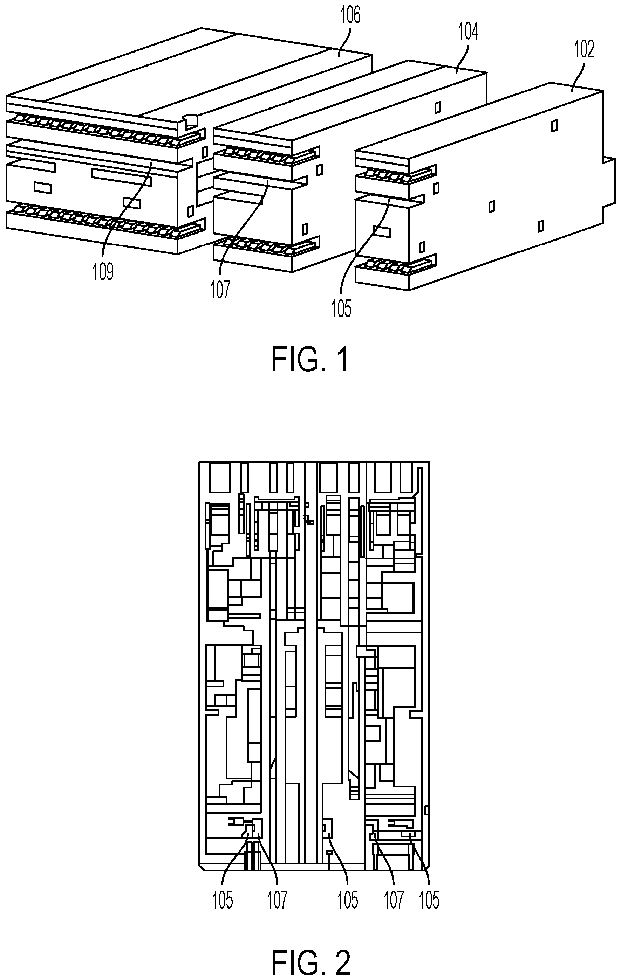

FIG. 1 illustrates examples of related art plug-in type circuit breakers. A plug-in type circuit breaker is a device used in electrical systems to protect circuits from overcurrent and short circuits. Plug-in type circuit breakers are designed to be plugged into an electrical panel, distribution board, a BFU shelf, or the like, and are typically modular in nature, allowing for easy installation and replacement without a need of rewiring. It should be understood that the circuit breakers discussed herein are plug-in type circuit breakers, though the phrase "plug-in" may be omitted from one or more individual references thereto. For example, FIG. 1 provides a view of a 1-63A plug-in circuit breaker 102, where 1-63A refers to a circuit breaker with a current rating of up to 63 amperes (A); a 80-125A plug-in circuit breaker 104, where 80-125A refers to a circuit breaker with a current rating of up to 125A; and a 200A plug-in circuit breaker 106, wherein 125A refers to a circuit breaker with a current rating of up to 200A. Thus, the current rating indicates a maximum current that a circuit breaker can handle before tripping or interrupting the flow of electricity. As shown in FIG. 1, the 1-63A circuit breaker 102 is physically smaller than the 80-125A circuit breaker 104, and the 80-125A circuit breaker 104 is physically smaller, in turn, than the 200A circuit breaker. Additionally, as shown in FIG. 1, the 1-63A circuit breaker 102 includes a connector 105, the 80-125A circuit breaker 104 includes a connector 107, and the 200A circuit breaker includes a connector 109, where each of the connectors is disposed in a different position on its respective circuit breaker . Specifically, for example, the connector 105 is located, with respect to the profile of the 1-63A circuit breaker 102, in a position different than the position, with respect to the profile of the 80-125A circuit breaker 104, on which the connector 107 is located. Due to the size differences and different positions of the connectors on the circuit breakers, the connector 105 of the 1-63A circuit breaker, the connector 107 of the 80-125A circuit breaker, and the connector 109 of the 200A circuit breaker, will align with different points on an inserted PCB.

In the descriptions herein of one or more example embodiments, 1-63A plug-in circuit breakers, 80-125A plug-in circuit breakers, and 200A circuit breakers are referenced. However, it should be understood that these particular types of circuit breakers are merely examples, and the circuit breakers used in conjunction with a PCB according to any one or more of the exampled embodiments may be any type of plug-in circuit breaker. Additionally, as will be better understood in view of the following descriptions, the PCBs described herein may be particularly configured such that the positions of edge connectors thereon may be determined based on the positions of connectors on one or more of any of a number of types of circuit breakers to be used in conjunction therewith.

One or more example embodiments described herein may provide an improved PCB that include features enabling the PCB to be universally compatible with any of a number of different circuit breaker configurations. For example, according to one or more example embodiments the positioning of a plurality of edge connectors of a PCB may accommodate connection to different sizes and types of plug-in circuit breakers. An example PCB described herein may also have a thickness of less than 1.2 mm or a thickness of about 1 mm to enable it to be connected within a small slot formed by a combination of plug-in circuit breakers. Such flexibility may allow for easier rearrangement and customization of a circuit breaker configuration without requiring changes to the PCB itself. One or more example embodiments described herein may also provide a PCB including alarm diodes connected to lines connected to the plurality of edge connectors, thereby effectively incorporating an alarm board into the PCB itself. One or more example embodiments described herein may also provide a PCB including edge connectors to be connected to one or more surge protection devices.

FIG. 2 illustrates an overlapping of an arrangement of three 1-63A circuit breakers with an arrangement of two 80-125A circuit breakers. Connectors 107 are connectors of the two 80-125A circuit breakers, respectively; and connectors 105 are connectors of the three 1-63A circuit breakers, respectively. As shown, none of the connectors 105 align with either of the connectors 107. Thus, FIG. 2 illustrates, for example, the difficulties associated with aligning fixed contact positions on a single PCB with connectors in any of various combinations of 1-63A circuit breakers and 80-125A circuit breakers.

One or more example embodiments described herein are directed to a PCB including a plurality of connectors configured to interface with connectors of any of a number of combinations of different types of circuit breakers. For example, according to one or more example embodiments, a PCB may include a plurality of edge connectors which are positioned to interface with either a connector of 1-63A plug-in circuit breaker or a connector of a 80-125A plug-in circuit breaker depending on the combination of circuit breakers into which the PCB is inserted. More specifically, each edge connector of an example PCB may be spaced at a distance apart from adjacent edge connectors, and/or spaced apart from a fixed position on the PCB, to thereby accommodate different configurations of plug-in type circuit breakers to be attached thereto, such that in each combination, the connector of each constituent circuit breaker will align with one of the plurality of edge connectors of the PCB.

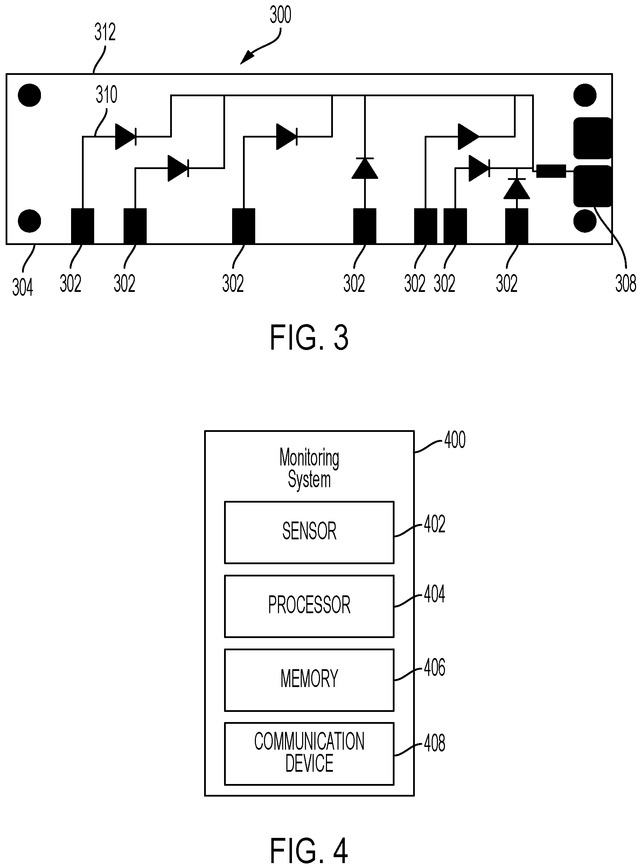

FIG. 3 illustrates a PCB configured to interface with any of a number of different configurations of plug-in circuit breakers, according to an example embodiment. As shown, in FIG. 3, a PCB 300 includes a plurality of edge connectors 302, each positioned along an edge 304 of the PCB 300. The positioning of the plurality of edge connectors 302 may be configured such that connectors of different types of circuit breakers included in each of a number of different circuit breaker combinations will be able to interface with one of the edge connectors 302. As discussed above, different types of circuit breakers may have different sizes and/or may include connectors in different positions thereon. For example, one or more of the plurality of edge connectors 302 may be spaced, relative to each other or relative to a fixed location on the PCB 300, to enable the PCB to interface with connectors of different types of circuit breakers, depending in the specific combination thereof, Thus, according to one or more example embodiments, a secure and reliable electrical connection between the PCB 300 and any of a number of different combinations of circuit breakers may be ensured, regardless of the specific types of circuit breakers included in the combination being used. Depending, for example, on the spacing of the edge connectors and whether the PCB is intended to be installed on a distribution shelf or a BFU shelf , the PCB 300 may be connected to configurations of circuit breakers including, but not limited to, 1-63A circuit breakers, 80-125A circuit breakers, and 200A circuit breakers. Of course, the types of circuit breakers to which the PCB 300 may be connected is not limited to these specific types of circuit breakers, and may be any type of plug-in circuit breaker, as would be understood by one of skill in the art.

According to one or more example embodiments, one or more of the plurality of edge connectors 302 may be a golden finger edge connector. The term "golden finger" as used herein refers to a somewhat finger-shaped conductive contact disposed at an edge of a PCB. A golden finger connector is made of a conductive material which may be, or may be plated with gold or another material such as, but not limited to copper and silver. Such golden finger connectors may be disposed at an edge of a PCB which is disposed at an end or a side portion of the PCB (e.g., the edge 304 of PCB 300). A golden finger connector may be configured to interface with a corresponding connector in another device such as, but not limited to a plug-in circuit breaker. A golden finger connector may provide a reliable and durable interface for electrical connections between devices and enable a smooth transmission of signals or data.

As shown in FIG. 3, the PCB 300 also includes connector lines a 310 that consolidate signals from the plurality of edge connectors 302 to a single connection pin 308. The connection pin 308 may be connected to a monitoring system, for example, an alarm board which can generate an alarm signal in the event of a failure or abnormality detected in a circuit breaker connected to PCB 300. The arrangement of connector lines 310 may take the place of separate wiring from each circuit breaker. The connection pin 308 may take the place of a separate collection board which might otherwise be required to route signals from each of the separate connectors 302 to a monitoring system or to a system controller. A monitoring system 400, according to an example embodiment, is discussed below with respect to FIG. 4. The connection pin 308 may be connected to a corresponding connector on a monitoring system or on a system controller. When a signal reaches an alarm board, for example, the signal is processed and interpreted by the alarm board. An alarm board may include any combination of software and hardware components configured to analyze signals from one or more circuit breakers and to generate appropriate alarm notifications and/or visual indicators or to route such to a system controller. In this way, an operator of an electrical system may be able to promptly identify and address any potential issues.

FIG. 4 illustrates a monitoring system 400 according to an example embodiment. The monitoring system 400 may be electrically coupled to each of the plurality of edge connectors 302 and thereby configured to detect a status of any circuit breaker connected to the PCB 300 via one of the plurality of edge connectors 302. For example, the monitoring system 400 may be connected to the plurality of edge connectors 302 via the connection pin 308. The monitoring system 400 may be configured to determine a status of any circuit breaker connected to one of the plurality of edge connectors 302 of the PCB 300, for example whether any such circuit breaker is tripped or operational. The monitoring system 400 includes one or more sensors 402, a processor 404, a memory 406, and a communication device 408. For example, the one or more sensors 402 sense a signal received from connection pin 308. The signal may include, for example, an electric current. The processor 404 may receive, from the one or more sensors 402, a signal corresponding to a sensed circuit breaker and may thereby determine a status of the sensed circuit breaker. Memory 406 may include instructions that, when executed by the processor 404, cause the processor 404 to: receive, from the one or more sensors 402, a signal corresponding to a sensed circuit breaker; determine, based on the signal, a status of the corresponding circuit breaker; and output an alert, via the communication device 408, indicating the status. For example, according to one or more example embodiments, communication device 408 may be controlled to emit an alarm indicating that one or more of the circuit breakers connected to the PCB 300 have a "tripped" status. Alternately, the communication device may output a signal to a system controller.

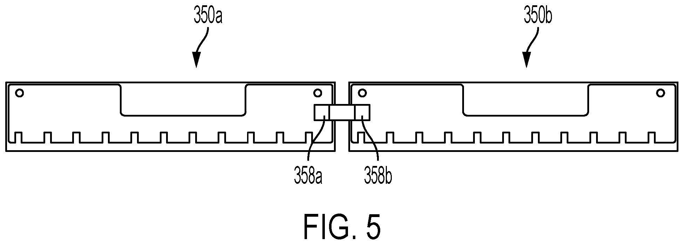

According to one or more example embodiments, the connection pin of one PCB, may be positioned such that it may be connected to the connection pin of another PCB. For example, FIG. 5 illustrates an arrangement in which a PCB 350a, including a connection pin 358a, and a PCB 350b, including a connection 358b, are connected via their respective connection pins 358a and 358b. According to one or more example embodiments, the PCB 350 and the PCB 350b may be connected to an external unit such as a monitoring system 400 and a system controller. In this case, each of the connection pin 358a and the connection pin 358b may be separately connected to the external unit, or, both of the PCB 350a and the PCB 350b may be connected to the external unit via a single one of the connection pin 358a and the connection pin 358b, because the connection pins 358a and 358b are also connected to each other.

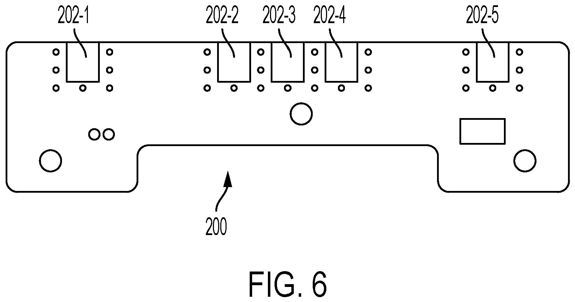

FIG. 6 illustrates a PCB configured for use in conjunction with an arrangement of circuit breakers in any of a number of configurations of different circuit breakers, according to an example embodiment. As shown in FIG. 6, a PCB 200 includes five edge connectors 202-1, 202-2, 202-3, 202-4, and 202-5. The edge connectors of the PCB 200 may be golden finger connectors, as discussed above. The edge connectors 202 are positioned to enable the PCB 200 to be connected to any of a number of different combinations of circuit breakers. The PCB 200 may be inserted into a circuit breaker combination including one or more 1-63A circuit breakers, one or more 80-125A circuit breakers, and/or one or more 200A circuit breakers. Of course, the types of circuit breakers to which the PCB 200 may be connected is not limited to these specific types of circuit breakers.

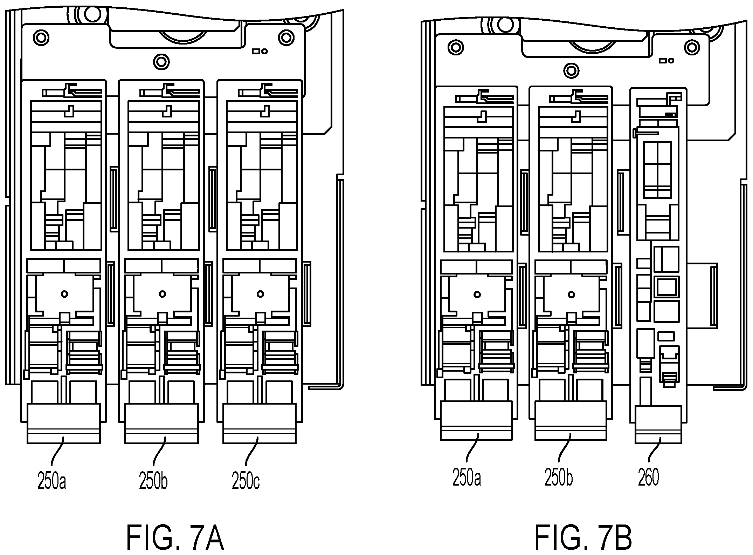

FIG. 7A illustrates a first example of the PCB of FIG. 6 inserted into a combination of circuit breakers, according to an example embodiment. As shown in FIG. 7A, the PCB 200 is inserted into a slot formed by three 80-125A circuit breakers 250, with the circuit breaker 250a connected to edge connector 202-1, the circuit breaker 250b connected to the edge connector 202-3, and the circuit breaker 250c connected to the edge connector 202-5.

FIG. 7B illustrates a second example of the PCB of FIG. 6 inserted into a combination of circuit breakers, according to an example embodiment. As shown in FIG. 7B, the PCB 200 is inserted into a slot formed by two 80-125A circuit breakers 250 and one 1-63A circuit breaker 260, with circuit breaker 250a connected to edge connector 202-1, circuit breaker 250b connected to edge connector 202-3, and circuit breaker 260 connected to edge connector 202-5.

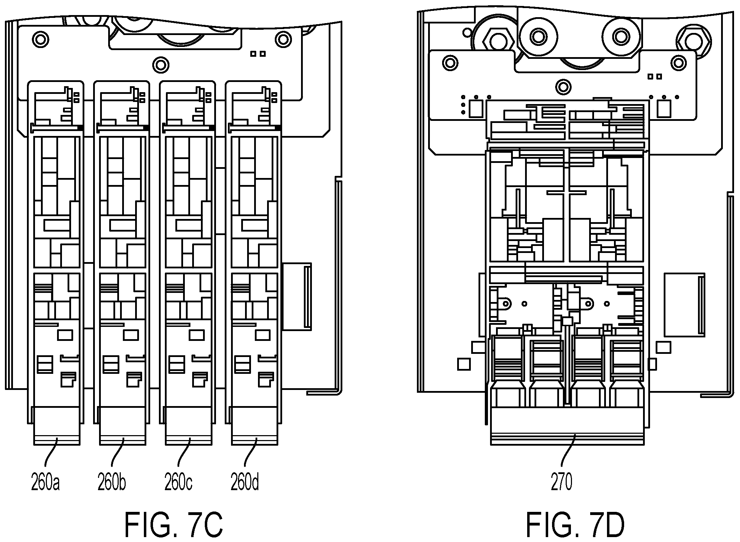

FIG. 7C illustrates a third example of the PCB of FIG. 6 inserted into a combination of circuit breakers according to an example embodiment. As shown in FIG. 7C, the PCB 200 is inserted into a slot formed by four 1-63A circuit breakers 260, with circuit breaker 260a connected to edge connector 202-1, circuit breaker 260b connected to edge connector 202-2, circuit breaker 260c connected to edge connector 202-4, and circuit breaker 260d connected to edge connector 202-5.

FIG. 7D illustrates a fourth example of the PCB of FIG. 6 inserted into a combination of circuit breakers according to an example embodiment. As shown in FIG. 7D, the PCB 200 is inserted into a slot formed by one 200A circuit breaker, with the circuit breaker 270 connected to the edge connector 202-2.

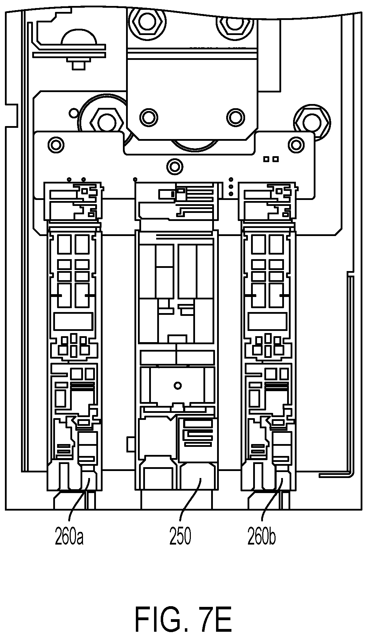

FIG. 7E illustrates a fifth example of the PCB of FIG. 6 inserted into a combination of circuit breakers according to an example embodiment. As shown in FIG. 7E, the PCB 200 is inserted into a slot formed by two 1-63A circuit breakers 270 and one 80-125A circuit breaker 250, with the circuit breaker 260a connected to edge connector 202-1, circuit breaker 250 connected to edge connector 202-3, and circuit breaker 260b connected to edge connector 202-5.

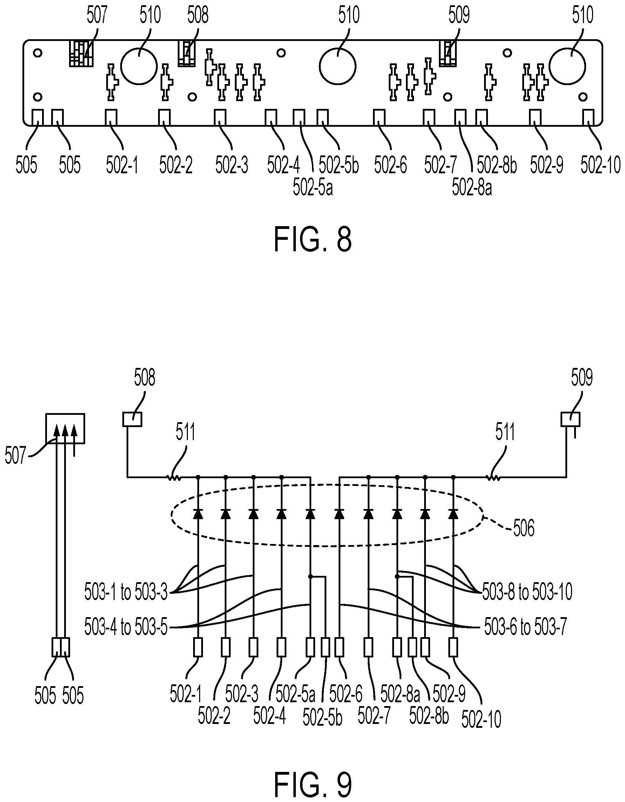

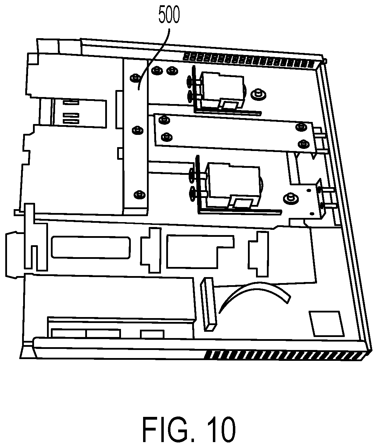

FIG. 8 illustrates a PCB configured for use in conjunction with a combination of circuit breakers included on a controller shelf of a direct current power distribution unit (DCDU), according to an example embodiment. FIG. 9 is a circuit diagram of the PCB of FIG. 8, according to an example embodiment. FIG. 10 is a perspective diagram of the PCB of FIG. 8 inserted into a combination of circuit breakers on a controller shelf, according to an example embodiment. As shown in FIGs. 8 and 9, a PCB 500 includes 12 edge connectors 502-1 through 502-10 electrically connected to 10 connector lines 503-1 through 503-10. As shown, each of the lines 503-5 and 503-8 is connected to a pair of adjacent edge connectors - line 503-5 is connected to edge connectors 502-5a and 502-5b, and line 503-8 is connected to edge connectors 502-8a and 5028b. The PCB 500 also includes edge connectors 505, configured to be connected to a direct current surge protective device (DC-SPD), 10 1A alarm diodes 506, a pin connector 507, a first alarm pin 508 to be connected to the system controller, a second alarm pin 509 to be connected to the system controller, openings 510 for mounting screws, and resistors 511. The edge connectors 505 are not connected to any diodes. Rather, the edge connectors, which may be golden fingers, as discussed above, are connected to an internal NC ("normally connected") switch of the SPD, and the alarm signal from the SPD is routed to the pin connector 507 which is, in turn, to be connected to the system controller. The 10 1A alarm diodes are each connected, via their anode, to the DC load side via one of alarm pins 508 and 509.

The edge connectors 502-1 through 502-10 on the PCB 500 are positioned to enable the PCB 500 to be connected to any of a number of different combinations of circuit breakers. According to one aspect, the PCB 500 may have example dimensions including: a depth, from the edge on which the connectors are aligned to the opposite edge, of about 35-40mm (or, e.g. 38mm); a length of about 245-249mm (or, e.g. 246.77mm); a spacing from a center of a (leftmost in FIG. 8) connector 505 to a center of a (rightmost in FIG. 8) connector 505 of about 7-10mm (or, e.g. 8.06mm); a spacing of a center of (rightmost in FIG. 8) connector 505 to C502-1 of about 21-25mm (or, e.g. 23.01mm); a spacing of C502-1 to C502-2 of about 21-25mm (or, e.g. 22.62mm); a spacing of C502-2 to C502-3 of about 21-25mm (or, e.g. 24.05mm); a spacing of C502-3 to C502-4 of about 21-25mm (or, e.g. 21.06mm); a spacing of C502-4 to C502-5a of about 12-14mm (or, e.g. 12.87mm); a spacing of C502-5a to C502-5b of about 9-11mm (or, e.g. 10.01mm); a spacing of C502-5b to C502-6 of about 21-25mm (or, e.g. 24.18mm); a spacing of C502-6 to C502-7 of about 20-25mm (or, e.g. 20.8mm); a spacing of C502-7 to C502-8a of about 12-15mm (or, e.g. 13.78mm); a spacing of C502-8a to C502-8b of about 7-10mm (or, e.g. 8.84mm); a spacing of C502-8b to C502-9 of about 20-25mm (or, e.g. 22.73mm); and a spacing of C502-9 to C502-10 of about 20-25mm (or, e.g. 22.38mm). In this case, the abbreviation C502-n refers to a center of an edge connector numbered 502-n.

According to a first example, the PCB 500 may be inserted into a slot formed in a circuit breaker combination including 10 1-63A circuit breakers, with each of the 10 1-63A circuit breakers connected to a respective one of edge connectors 502-1, 502-2, 502-3, 502-4, 502-5a, 502-6, 502-7, 502-8a, 502-9, and 502-10. According to a second example, the PCB 500 may be inserted into a slot formed in a circuit breaker combination including four 80-125A circuit breakers and six 1-63A circuit breakers. Any one or more of the edge connectors can be connected to a 1-63A circuit breaker, and any of edge connectors 502-3, 502-5a, 502-5b, 502-7, 502-8a, and 502-8b may be connected to an 80-125A circuit breaker According to either of these examples, the PCB 500 may also be connected, via edge connectors 505 to a DC-SPD. Additionally, as the PCB 500 includes an alarm diode 506 connected to each line 503, and thus connected to each of the of the edge connectors 502, no further connection of the PCB to a collection board or alarm board is needed, and the PCB 500 may be directly connected to the system controller via alarm pins 508 and 509. Thus, the PCB 500 enables a single, 1 millimeter (mm), backboard to collect alarm signals from each connected circuit breaker and direct them to a system controller, for many different combinations of circuit boards. Of course, the types of circuit breakers to which the PCB 500 may be connected is not limited to 80-125A and 1-63A circuit breakers, as would be understood by one of skill in the art. The PCB 500 may also be connected to one or more 200A circuit breakers, or any other type of plug-in circuit breaker, as would be understood by one of skill in the art. The edge connectors of the PCB 500 may be golden finger connectors, as discussed above.

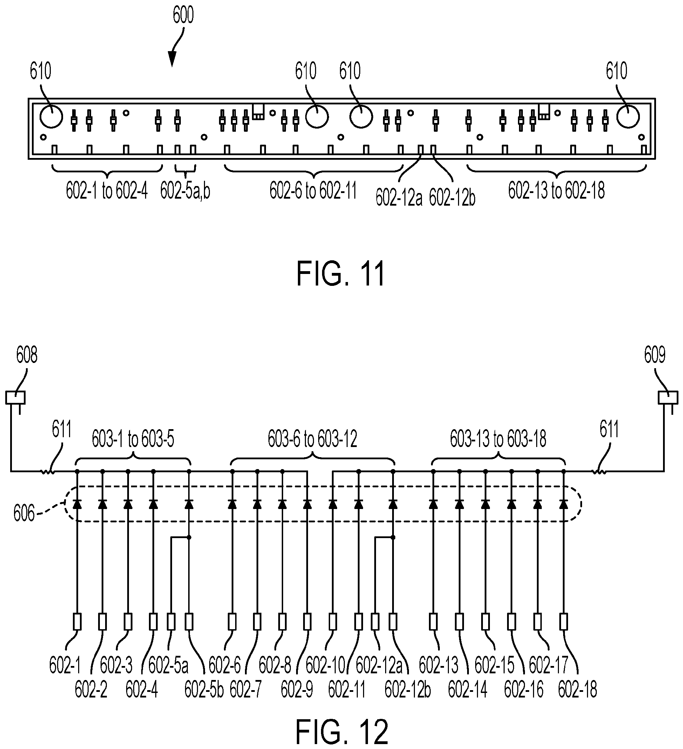

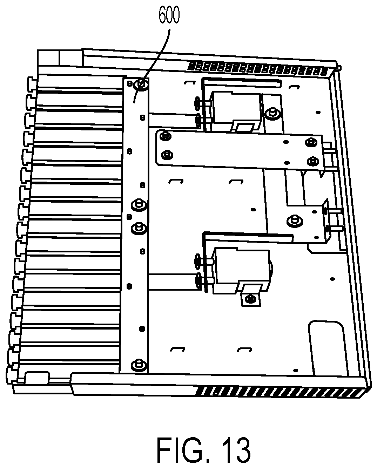

FIG. 11 illustrates a PCB configured for use in conjunction with a combination of circuit breakers included on a DCDU shelf, according to an example embodiment. FIG. 12 is a circuit diagram of the PCB of FIG. 11. FIG. 13 is a perspective diagram of the PCB of FIG. 11 inserted into a combination of circuit breakers on a DCDU shelf, according to an example embodiment. As shown in FIGs. 11 and 12, a PCB 600 includes 20 connectors 602-1 through 602-18 electrically connected to 18 connector lines 603-1 through 603-18. As shown, each of the lines 603-5 and 603-12 is connected to a pair of adjacent connectors - line 603-5 is connected to connectors 602-5a and 602-5b, and line 603-12 is connected to connectors 602-12a and 603-12b. The PCB 600 also includes a first alarm pin 608 to be connected to the system controller, a second alarm pin 609 to be connected to the system controller, openings 610 for mounting screws, and resistors 611. The edge connectors of the PCB 600 may be golden finger connectors, as discussed above.

The connectors 602-1 through 602-18 on the PCB 600 are positioned to enable the PCB to be connected to any of a number of different combinations of circuit breakers. According to one aspect, the PCB 600 may have example dimensions including: a depth of about 35-40mm (or, e.g. 37.05mm); a length of about 400-410mm (or, e.g. 403.83mm); a spacing of C602-1 to C602-2 of about 20-25mm (or, e.g. 22.88mm); a spacing of C602-2 to C602-3 of about 20-25mm (or, e.g. 23.92mm); a spacing of C602-3 to C602-4 of about 20-25mm (or, e.g. 21.19mm); a spacing of C602-4 to C602-5a of about 11-14mm (or, e.g. 12.48mm); a spacing of C602-5a to C602-5b of about 8-11mm (or, e.g. 9.88mm); a spacing of C602-5b to C602-6 of about 20-25mm (or, e.g. 22.49mm); a spacing of C-602-6 to C602-7 of about 20-25mm (or, e.g. 23.01mm); a spacing of C602-7 to C602-8 of about 20-25mm (or, e.g. 22.62mm); a spacing of C602-8 to C602-9 of about 20-25mm (or, e.g. 22.36mm); a spacing of C602-9 to C602-10 of about 20-25mm (or, e.g. 24.18mm); a spacing of C602-10 to C602-11 of about 20-25mm (or, e.g. 21.32mm); a spacing of C602-11 to C602-12a of about 11-14mm (or, e.g. 12.79mm); a spacing of C602-12a to C602-12b of about 8-11mm (or, e.g. 9.62mm); a spacing of C602-12b to C602-13 of about 20-25mm (or, e.g. 22.62mm); a spacing of C602-13 to C602-14 of about 20-25mm (or, e.g. 22.62mm); a spacing of C602-14 to C602-15 of about 20-25mm (or, e.g. 22.49mm); a spacing of C602-15 to C602-16 of about 20-25mm (or, e.g. 22.62mm); a spacing of C602-16 to C602-17 of about 20-25mm (or, e.g. 22.75mm); and a spacing of C602-17 to C602-18 of about 20-25mm (or, e.g. 22.49mm). In this case, the abbreviation C602-n refers to a center of an edge connector numbered 602-n.

The PCB 600 may be inserted into a circuit breaker combination including 1-63A circuit breakers and/or 80-125A circuit breakers. According to a first example, the PCB 600 may be inserted into a circuit breaker combination including 18 1-63A circuit breakers, with each of the 18 1-63A circuit breakers connected to one of connectors 602-1, 602-2, 602-3, 602-4, 602-5a, 602-6, 602-7, 602-8, 602-9, 602-10, 602-11, 602-12a, 602-13, 602-14, 602-15, 602-16, 602-17, and 602-18. According to another example, the PCB 600 may be inserted into a circuit breaker combination including four 80-125A circuit breakers, with each of the four 80-125A circuit breakers connected to one of edge connectors 602-3, 602-5a, 602-10 and 602-12a. In this example, additionally, 12 1-63A circuit breakers could simultaneously connect to the PCB 600, with each of the 12 1-63A circuit breakers connected to one of edge connectors 602-1, 602-2, 602-6, 602-7, 602-8, 602-9, 602-13, 602-14, 602-15, 602-16, 602-17, and 602-18. Of course, the types of circuit breakers to which the PCB 600 may be connected is not limited to 80-125A and 1-63A circuit breakers, as would be understood by one of skill in the art. The PCB 500 may be connected to one or more 200A circuit breakers, or any other type of plug-in circuit breaker, as would be understood by one of skill in the art.

Additionally, as the PCB 600 includes an alarm diode 606 connected on each line 603, and thus connected to each of the edge connectors 602, no further connection of the PCB to an alarm board is needed, and the PCB 600 may be directly connected to the system controller via alarm pins 608 and 609. As shown, for example, in FIG. 12, the PCB 600 includes two, separate groups of edge connectors and diodes: a first group including edge connectors 602-1 through 602-9 and the diodes 606 attached thereto and to the first alarm pin 608, and a second group including edge connectors 602-10 through 602-18 and the diodes attached thereto and to the second alarm pin 609. Thus, the PCB 600 enables two groups of circuit breakers to be connected to a single PCB, as an alternative to two separate PCBs attached together, as discussed above for example with respect to FIG. 5. Thus, the PCB 600 enables a single, 1 mm, backboard to collect alarm signals from each connected circuit breaker and direct them to a system controller, for many different combinations of circuit boards.

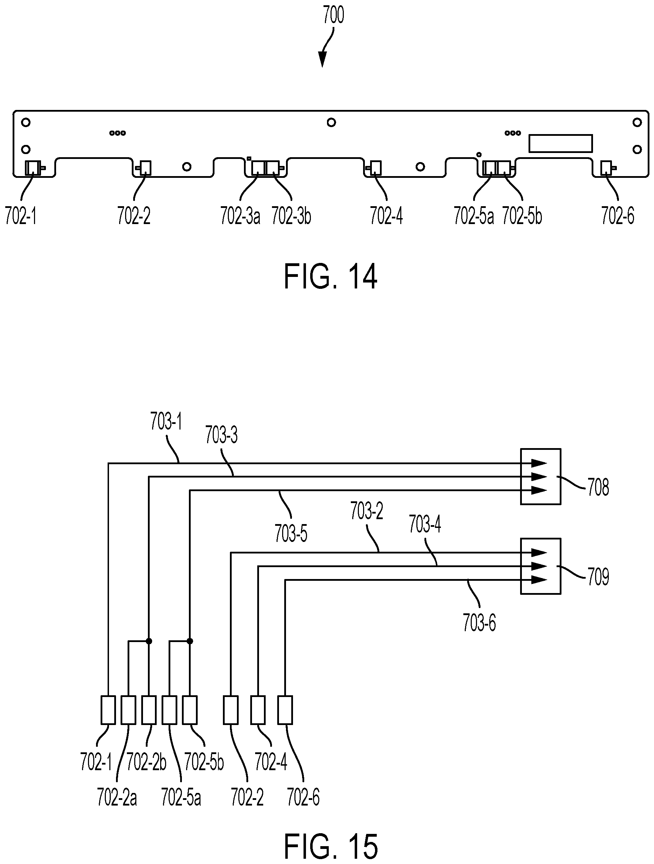

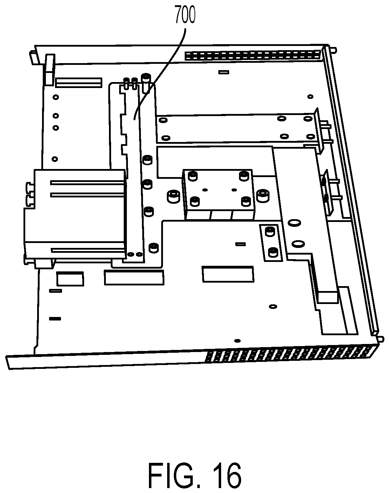

FIG. 14 illustrates a PCB configured for use in conjunction with a combination of circuit breakers included on a BFU shelf, according to an example embodiment. FIG. 15 is a circuit diagram of the PCB of FIG. 14, according to an example embodiment. FIG. 16 is a perspective diagram of the PCB of FIG. 14 inserted into a combination of circuit breakers on a BFU shelf, according to an example embodiment. As shown in FIG. 14 and FIG. 15, a PCB 700 includes eight edge connectors 702-1 through 702-6 connected to six connector lines 703-1 through 703-6. As shown, each of the lines 703-3 and 703-5 is connected to a pair of adjacent edge connectors - line 703-3 is connected to edge connectors 702-3a and 702-3b, and line 703-5 is connected to edge connectors 702-5a and 702-5b. The PCB also includes a first pin 708 and a second pin 709, each to be connected to the system controller. The edge connectors of the PCB 700 may be golden finger connectors, as discussed above. As with the example embodiment discussed with respect to FIGs. 11-13, the PCB 700 also includes two, separate groups of edge connectors: a first group including edge connectors 702-1, 702-2a, 702-2b, 702-5a, and 702-5b and the first pin 708 connected thereto, and a second group including edge connectors 702-2, 702-4, and 702-6 and the second pin 709 connected thereto. Additionally, according to this example embodiment, the PCB 700 does not include any diodes, and the system controller connected to the first and second pins 708 and 709 can determine a difference between a system voltage and a battery voltage to create an alarm, as needed, in case one or more of the circuit breakers attached thereto is tripped.

The edge connectors 702-1 through 702-6 are positioned to enable the PCB 700 to be connected to any of a number of different combinations of battery circuit breakers. According to one aspect, the PCB 700 may have example dimensions including: a depth of about 26-30mm (or, e.g. 28.3mm); a length of about 270-285mm (or, e.g. 272.05mm); a spacing of C702-1 to C702-2 of about 45-49mm (or, e.g. 47.97mm); a spacing of C702-2 to C702-3a of about 45-49mm (or, e.g. 47.84mm); a spacing of C702-3a to C702-3b of about 4-7mm (or., e.g. 5.95mm); a spacing of C702-3b to C702-4 of about 45-49mm (or, e.g. 45.01mm); a spacing of C702-4 to C702-5a of about 45-49mm (or, e.g. 47.84mm); a spacing of C702-5a to C702-5b of about 4-7mm (or, e.g. 5.82mm); and a spacing of C702-5b to C702-6 of about 45-49mm (or, e.g. 45.4mm). In this case, the abbreviation C702-n refers to a center of an edge connector numbered 702-n.

According to a first example, the PCB 700 may be inserted into a circuit breaker combination including six 80-125A circuit breakers, with each of the six 80-125A circuit breakers connected to one of edge connectors 702-1, 702-2, 702-3a, 702-4, 702-5a, and 702-6. According to a second example, the PCB may be inserted into a circuit breaker combination including three 200A battery circuit breakers, with each of the three 200A battery circuit breakers connected to one of edge connectors 702-1, 702-3a, and 702-5a. Of course, the types of circuit breakers to which the PCB 500 may be connected is not limited to 80-125A, 1-63A, and 200A circuit breakers, as would be understood by one of skill in the art. The PCB 500 may also be connected to one or more of any other type of plug-in circuit breaker, as would be understood by one of skill in the art.

Additionally, as the PCB 700 may be connected to the system controller via pins 508 and 509. Thus, the PCB 500 enables a single, 1mm backboard to be connected to each circuit breaker and direct them to a system controller, for many different combinations of circuit boards.

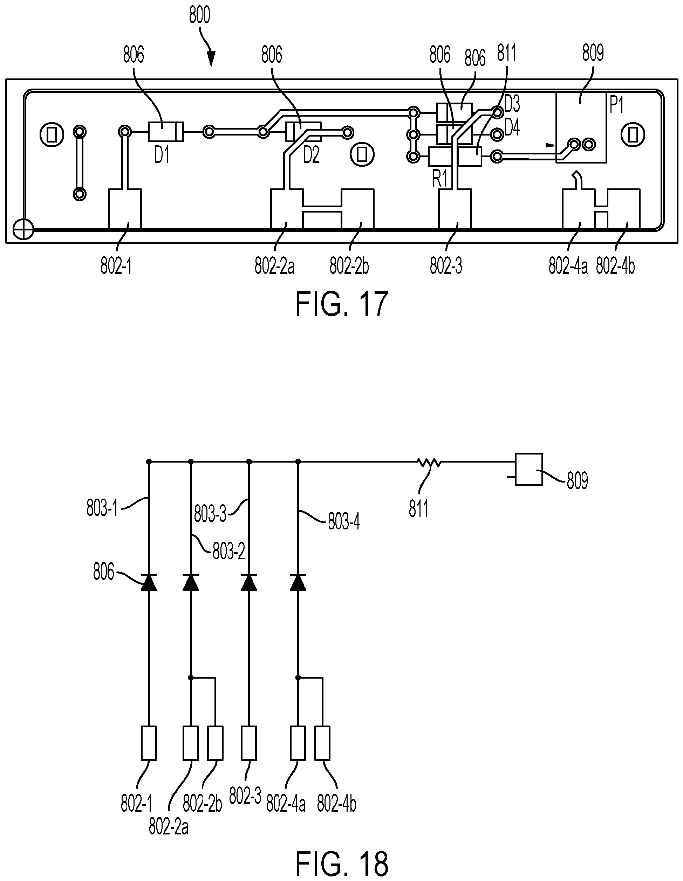

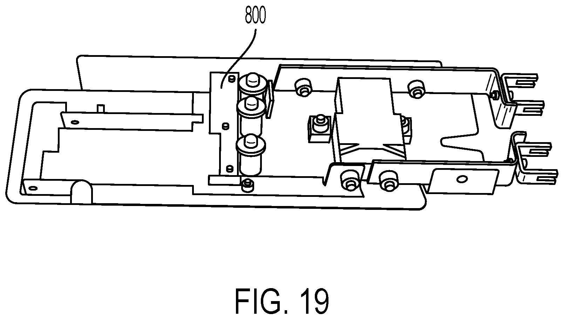

FIG. 17 illustrates a PCB configured to use in conjunction with a combination of circuit breakers included in a DCDU box, according to an example embodiment. FIG. 18 is a circuit diagram of the PCB of FIG. 17. FIG. 19 is a perspective diagram of the PCB of FIG. 17 inserted into a combination of circuit breakers in a DCDU box, according to an example embodiment. As shown in FIG. 17 and FIG. 18, a PCB 800 includes six edge connectors 802-1 through 802-4 electrically connected to four connector lines 803-1 through 803-4. As shown, each of the lines 803-2 and 803-4 is connected to a pair of adjacent edge connectors - line 803-2 is connected to edge connectors 802-2a and 802-2b, and line 803-4 is connected to edge connectors 802-4a and 802-4b. The PCB also includes a 1A alarm diode 806 connected on each of the lines 803-1 through 803-4, a resistor 811, and a pin 809 to be connected to the system controller. The edge connectors of the PCB 800 may be golden finger connectors, as discussed above.

The edge connectors 802-1 through 802-4 are positioned to enable the PCB 800 to be connected to any number of different combinations of circuit breakers. According to one aspect, the PCB 800 may have example dimensions including: a depth of about 21-24mm (or, e.g. 22.05mm); a length of about 95-100mm (or, e.g. 97.65mm); a spacing C802-1 to C802-2a of about 22-26mm (or, e.g. 24.31mm); a spacing of C802-2a to C802-2b of about 9-12mm (or, e.g. 10.66mm); a spacing of C802-2b to C802-3 of about 13-16mm (or, e.g. 14.95); a spacing of C802-3 to C802-4a of about 17-20mm (or, e.g. 18.7mm); and a spacing of C802-4a to C802-4b of about 5-8mm (or, e.g. 6.89mm). In this case, the abbreviation C802-n refers to a center of an edge connector numbered 802-n.

According to a first example, the PCB 800 may be inserted into a circuit breaker combination including four 1-63A circuit breakers, with each of the four 1-63A circuit breakers connected to one of edge connectors 802-1, 802-2a, 802-3, and 802-4a. According to another example, the PCB 800 may be inserted into a circuit breaker combination including three 80-125A circuit breakers, with each of the three 80-125A circuit breakers connected to one of edge connectors 802-1, 802-2b, and 802-4b. Of course, the types of circuit breakers to which the PCB 800 may be connected is not limited to 80-125A and 1-63A circuit breakers, as would be understood by one of skill in the art. the PCB 800 may also be connected to one or more 200A circuit breakers, or any other type of plug-in circuit breaker, as would be understood by one of skill in the art.

Additionally, as the PCB 800 includes an alarm diode 806 connected on each line 803 and thus connected to each of the edge connectors 802, no further connection of the PCB 800 to an alarm board is needed, and the PCB 800 may be directly connected to the system controller via pin 809. Thus, the PCB 800 enables a single, 1mm thickness backboard to collect alarm signals from each connected circuit breaker and direct them to the system controller, for many different combinations of circuit boards.

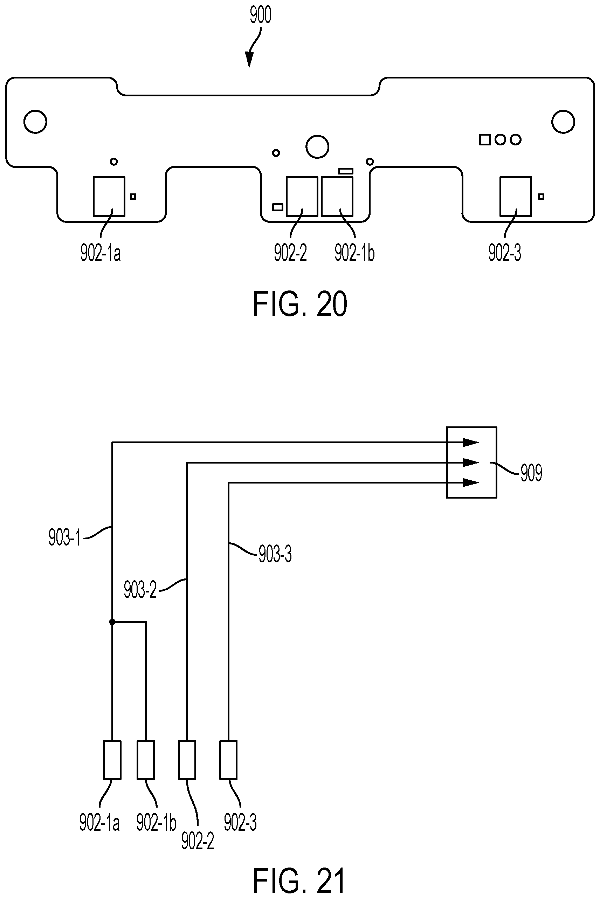

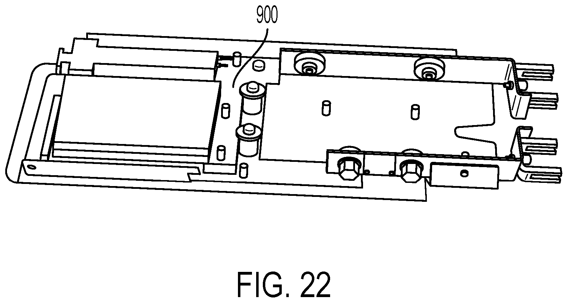

FIG. 20 illustrates a PCB configured to use in conjunction with a combination of circuit breakers in a battery fuse unit (BFU) box, according to an example embodiment. FIG. 21 is a circuit diagram of the PCB of FIG. 20. FIG. 22 is a perspective diagram of the PCB of FIG. 20 inserted into a circuit breaker in a BFU box, according to an example embodiment. As shown in FIGs. 20 and 21, a PCB 900 includes four edge connectors 902-1 through 902-3 electrically connected to three connector lines 903-1 through 903-3. As shown, connector line 903-1 is connected to a pair of adjacent edge connectors 902-1a and 902-1b. The PCB also includes a pin 909 to be connected to a system controller. The edge connectors of the PCB 900 may be golden finger connectors, as discussed above.

The edge connectors 902 are positioned on the PCB 900 to enable the PCB to be connected to any of a number of different combinations of circuit breakers. According to one aspect, the PCB 900 may have example dimensions including: a depth of about 20-24mm (or, e.g. 22.0mm5); a length of about 95-100mm (or, e.g. 97.65mm); a spacing of C902-1a to C902-2 of about 30-33mm (or, e.g. 31.59mm); a spacing of C902-2 to C902-1b of about 5-9mm (or, e.g. 6.73mm); and a spacing of C902-1b to C902-3 of about 25-29mm (or, e.g. 27.46mm). In this case, the abbreviation C902-n refers to a center of an edge connector numbered 902-n.

The PCB 900 may be inserted into a circuit breaker combination including a 200A battery circuit breaker and/or an 80-125A battery circuit breaker. According to a first example, the PCB 900 may be inserted into a single 200A battery circuit breaker, with the circuit breaker connected to the edge connector 902-1b. According to another example embodiment, the PCB 900 may be inserted into a circuit breaker combination including three 80-125A circuit breakers, with each one of the three circuit breakers connected to one of edge connectors 902-1, 902-2b, and 902-3. Of course, the types of circuit breakers to which the PCB 900 may be connected is not limited to 80-125A, 1-63A, and 200A circuit breakers. The PCB 900 may also be connected to one or more of any other type of plug-in circuit breaker, as would be understood by one of skill in the art. Thus, the PCB 900 enables a single 1mm backboard to be connected to each connected circuit breaker and also to the system controller. According to this example embodiment, as also discussed above with respect to the PCB of FIGs. 11-13, the PCB 900 provides a connection between the circuit breakers attached thereto and the system controller, such that the system controller itself can determine a difference between a system voltage and a battery voltage to create an alarm, as needed, in case one or more of the circuit breakers attached thereto is tripped.

According to one or more example embodiments, a PCB is provided including a plurality of edge connectors disposed on the PCB such that the PCB is configured to be inserted into a combination of circuit breakers including one or more circuit breakers of any of a number of different types. The PCB may additionally include line connectors connecting each of the edge connectors to one or more pin connectors, and may include a diode disposed on a line connector between each one of the plurality of edge connectors and the one or more pin connectors, thus obviating the need for a separate alarm board and enabling an alarm signal to be directly routed from the PCB to a system controller. The PCB according to one or more example embodiments may have a thickness of about 1mm. The PCB according to one or more example embodiments may also include one or more connectors to enable the PCB to be directly connected to one or more surge protection devices.

Further examples are set out in the clauses below:
1. A system, comprising:
   a printed circuit board (PCB); and
   a plurality of edge connectors positioned at an edge of the PCB, wherein at least one edge connector of the plurality of edge connectors is configured to interface with a connector of a first type of plug-in circuit breaker and a connector of a second type of plug-in circuit breaker, and
   wherein a position of the connector of the first type of plug-in circuit breaker is different from a position of the connector of the second type of plug-in circuit breaker.
2. The system of clause 1, wherein spacing between adjacent edge connectors of the plurality of edge connectors is configured to enable the PCB to interface with a plurality of configurations comprising the first type of plug-in circuit breaker and the second type of plug-in circuit breaker.
3. The system of clause 2, wherein the plurality of configurations includes at least one of:
   three 125A plug-in circuit breakers, two 125A and one 63A plug-in circuit breakers, four 63A plug-in circuit breakers, one 200A plug-in circuit breaker, or one 125A and two 63A plug-in circuit breakers.
4. The system of any one of the preceding clauses, wherein the first type of plug-in circuit breaker is a different size from the second type of plug-in circuit breaker.
5. The system of any one of the preceding clauses, wherein the first type of plug-in circuit breaker is a 63A type plug-in circuit breaker.
6. The system of any one of the preceding clauses, wherein the second type of plug-in circuit breaker is a 125A type plug-in circuit breaker.
7. The system of any one of the preceding clauses, wherein each edge connector of the plurality of edge connectors is configured as a golden finger.
8. The system of any one of the preceding clauses, further comprising a monitoring system in electrical communication with each connector of the plurality of edge connectors and configured to detect a status of at least some plug-in circuit breakers connected to the PCB.
9. A printed circuit board (PCB), comprising:
   a plurality of edge connectors positioned at an edge of the PCB, wherein at least one edge connector of the plurality of edge connectors is configured to interface with a connector of a first type of plug-in circuit breaker and a connector of a second type of plug-in circuit breaker, and
   wherein a position of the connector of the first type of plug-in circuit breaker is different from a position of the connector of the second type of plug-in circuit breaker.
10. The PCB of clause 9, wherein spacing between adjacent edge connectors of the plurality of edge connectors is configured to enable the PCB to interface with a plurality of configurations comprising the first type of plug-in circuit breaker and the second type of plug-in circuit breaker.
11. The PCB of clause 10, wherein the plurality of configurations includes at least one of: three 125A plug-in circuit breakers, two 125A and one 63A plug-in circuit breakers, four 63A plug-in circuit breakers, one 200A plug-in circuit breaker, or one 125A and two 63A plug-in circuit breakers.
12. The PCB of clause 9, wherein the first type of plug-in circuit breaker is a different size from the second type of plug-in circuit breaker.
13. The PCB of clause 9, wherein the first type of plug-in circuit breaker is a 63A type plug-in circuit breaker.
14. The PCB of any one of clause 9 to 13, wherein the second type of plug-in circuit breaker is a 125A type plug-in circuit breaker.
15. The PCB of any one of clause 9 to 13, wherein each edge connector of the plurality of edge connectors is configured as a golden
16. A printed circuit board (PCB), comprising:
   a plurality of edge connectors positioned at an edge of the PCB and configured as a golden finger, wherein at least one edge connector of the plurality of edge connectors is configured to interface with a connector of a first type of plug-in circuit breaker and a connector of a second type of plug-in circuit breaker, and wherein a position of the connector of the first type of plug-in circuit breaker is different from a position of the connector of the second type of plug-in circuit breaker.
17. The PCB of clause 16, wherein spacing between each adjacent edge connectors of the plurality of edge connectors is configured to enable the PCB to interface with a plurality of configurations comprising the first type of plug-in circuit breaker and the second type of plug-in circuit breaker.
18. The PCB of clause 17, wherein the plurality of configurations includes at least one of:
   three 125A plug-in circuit breakers, two 125A and one 63A plug-in circuit breakers, four 63A plug-in circuit breakers, one 200A plug-in circuit breaker, or one 125A and two 63A plug-in circuit breakers.
19. The PCB of clause 16, wherein the first type of plug-in circuit breaker is a 63A type plug-in circuit breaker.
20. The PCB of any one of clauses 16 to 19, wherein the second type of plug-in circuit breaker is a 125A type plug-in circuit breaker.

Further examples are set out in the items below:
1. A printed circuit board comprising:
   a plurality of edge connectors;
   a pin connector;
   a plurality of electrical lines, each electrically connecting one of the plurality of edge connectors to the pin connector;
   wherein each of the plurality of edge connectors is positioned on the printed circuit board to enable the plurality of edge connectors to interface with connectors of a plurality of configurations of circuit breakers, comprising at least:
      a first configuration comprising a circuit breaker of a first type, and
      a second configuration comprising a circuit breaker of a second type;
      wherein a position of a connector on the circuit breaker of the first type is different from a position of a connector on the circuit breaker of the second type; and
      wherein the printed circuit board has a thickness of not greater than 1.2 mm.
2. The printed circuit board according to item 1, wherein the circuit breaker of the first type is a 1-63 ampere (A) circuit breaker, and the circuit breaker of the second type is a 80-125A circuit breaker.
3. The printed circuit board according to item 1,
   wherein the circuit breaker of the first type is a 80-125 ampere (A) circuit breaker, and the circuit breaker of the second type is a 200A circuit breaker.
4. The printed circuit board according to any one of the preceding items, further comprising:
   at least one connector configured to be electrically connected to a direct current surge protective device.
5. The printed circuit board according to any one of the preceding items, wherein each of the plurality of edge connectors comprises a golden finger connector.
6. A printed circuit board comprising:
   a plurality of edge connectors, the plurality of edge connectors comprising at least one single edge connector and a pair of two dual edge connectors;
   a pin connector;
   a plurality of electrical lines comprising:
      at least one individual electrical line electrically connected between a single edge connector of the plurality of edge connectors and the pin connector, and
      at least one dual electrical line electrically connected between the pair of dual edge connectors and the at least one pin connector;
      a plurality of diodes, wherein one of the plurality of diodes is connected on one of the plurality of electrical lines;
      wherein each of the plurality of edge connectors is positioned on the printed circuit board to enable the plurality of edge connectors to interface with connectors of a plurality of configurations of circuit breakers, comprising at least:
         a first configuration comprising a circuit breaker of a first type, and
         a second configuration comprising a circuit breaker of a second type;
         wherein a position of a connector on the circuit breaker of the first type is different from a position of a connector on the circuit breaker of the second type; and
         wherein the printed circuit board has a thickness of not greater than 1.2 mm.
7. The printed circuit board according to item 6, wherein the circuit breaker of the first type is a 1-63 ampere (A) circuit breaker, and the circuit breaker of the second type is a 80-125A circuit breaker.
8. The printed circuit board according to item 6,
   wherein the circuit breaker of the first type is a 80-125 ampere (A) circuit breaker, and the circuit breaker of the second type is a 200A circuit breaker.
9. The printed circuit board according to any one of items 6-8, further comprising:
   at least one connector configured to be electrically connected to a direct current surge protective device.
10. The printed circuit board according to any one of items 6-8, wherein each of the plurality of edge connectors comprises a golden finger connector.

It may be understood that the example embodiments described herein may be considered in a descriptive sense only and not for purposes of limitation. Descriptions of features or aspects within each example embodiment may be considered as available for other similar features or aspects in other example embodiments.

While example embodiments have been described with reference to the figures, it will be understood by those of ordinary skill in the art that various changes in form and details may be made therein without departing from the scope as defined by the following claims.

## Claims

1. A printed circuit board comprising:
a plurality of edge connectors;
a pin connector;
a plurality of electrical lines,
wherein each of the plurality of edge connectors is positioned on the printed circuit board to enable the plurality of edge connectors to interface with connectors of a plurality of configurations of circuit breakers, comprising at least:
a first configuration comprising a circuit breaker of a first type, and
a second configuration comprising a circuit breaker of a second type;
wherein a position of a connector on the circuit breaker of the first type is different from a position of a connector on the circuit breaker of the second type; and
wherein the printed circuit board has a thickness of not greater than 1.2 mm.

2. The printed circuit board according to claim 1, wherein the plurality of electrical lines each electrically connect one of the plurality of edge connectors to the pin connector.

3. The printed circuit board according to claim 1 or claim 2, wherein the circuit breaker of the first type is a 1-63 ampere (A) circuit breaker, and the circuit breaker of the second type is a 80-125A circuit breaker.

4. The printed circuit board according to claim 1 or claim 2,
wherein the circuit breaker of the first type is a 80-125 ampere (A) circuit breaker, and the circuit breaker of the second type is a 200A circuit breaker.

5. The printed circuit board according to any one of the preceding claims, further comprising:
at least one connector configured to be electrically connected to a direct current surge protective device.

6. The printed circuit board any one of the preceding claims, wherein each of the plurality of edge connectors comprises a golden finger connector.

7. The printed circuit board according to claim 1,
the plurality of edge connectors comprising at least one single edge connector and a pair of two dual edge connectors;
the plurality of electrical lines comprising:
at least one individual electrical line electrically connected between a single edge connector of the plurality of edge connectors and the pin connector, and
at least one dual electrical line electrically connected between the pair of dual edge connectors and the at least one pin connector;
a plurality of diodes, wherein one of the plurality of diodes is connected on one of the plurality of electrical lines.

8. The printed circuit board according to claim 7, wherein the circuit breaker of the first type is a 1-63 ampere (A) circuit breaker, and the circuit breaker of the second type is a 80-125A circuit breaker.

9. The printed circuit board according to claim 7,
wherein the circuit breaker of the first type is a 80-125 ampere (A) circuit breaker, and the circuit breaker of the second type is a 200A circuit breaker.

10. The printed circuit board according to any one of claims 7-9, further comprising:
at least one connector configured to be electrically connected to a direct current surge protective device.

11. The printed circuit board according to any one of claims 7-10, wherein each of the plurality of edge connectors comprises a golden finger connector.
